# EUROPEAN PATENT APPLICATION

(11) **EP 4 181 359 A1**
(43) Date of publication of application: **17.05.2023**
(21) Application number: 22206463.6
(22) Date of filing: 09.11.2022
(51) Int. Cl.: H02K 9/19, B60L 3/00

(54) **OIL TEMPERATURE CONTROL METHOD, CONTROLLER, POWERTRAIN, AND ELECTRIC VEHICLE**

(30) Priority: 10.11.2021 CN 202111331434
(71) Applicant: Huawei Digital Power Technologies Co., Ltd., Shenzhen, 518043 (CN)
(72) Inventor: WANG, Jiangang, Shenzhen, 518043 (CN); LI, Jiyang, Shenzhen, 518043 (CN)
(74) Representative: Gill Jennings & Every LLP

(57) **Abstract**

Embodiments of this application disclose an oil temperature control method, a controller, a powertrain, and an electric vehicle. The oil temperature control method, applied to a controller of an electric vehicle that includes an oil cooling circuit, where the oil cooling circuit flows through a motor and an inverter. The method includes the following steps: determining an oil temperature at a detection point, where the detection point is a specified location in the oil cooling circuit; when the oil temperature is lower than a first target temperature, triggering one or more of the following operations: bypassing an oil-water heat exchanger, reducing a water flow rate, and increasing a power of an oil pump; or when the oil temperature is higher than a second target temperature, triggering one or more of the following operations: disabling a bypass path of an oil-water heat exchanger, increasing a water flow rate, and reducing a power of an oil pump. By using the technical solutions provided in embodiments of this application, an oil temperature in an oil cooling circuit can be controlled within a target temperature range.

## Description

### TECHNICAL FIELD

This application relates to the field of electric vehicle technologies, and in particular, to an oil temperature control method, a controller, a powertrain, and an electric vehicle.

### BACKGROUND

A powertrain of an electric vehicle includes a motor, an inverter, a cooling system, and the like. With technology evolution, a cooling system in the powertrain dissipates heat for a motor, an inverter, and the like by using an oil cooling circuit, and transfers heat of the oil cooling circuit to a water cooling circuit by using an oil-water heat exchanger.

However, viscosity of an oil coolant varies greatly with temperature. The viscosity increases at a low temperature. In this case, heat exchange capability decreases. In an actual test, when a temperature of an oil coolant of a brand is 40°C, viscosity is 24.9 mPa·s; and when the temperature is -40°C, the viscosity is 12030 mPa·s. There is an increase of three orders of magnitude, and correspondingly a heat dissipation effect is also much worse. Therefore, how to control an oil temperature of the oil coolant to be within a specific range to avoid great degradation of heat dissipation performance of the powertrain due to large-scale fluctuation of oil temperatures is an urgent problem that needs to be resolved.

### SUMMARY

Embodiments of this application provide an oil temperature control method, a controller, a powertrain, and an electric vehicle, so as to control an oil temperature in an oil cooling circuit to be within a target temperature range.

According to a first aspect, an embodiment of this application provides an oil temperature control method, applied to a controller of an electric vehicle that includes an oil cooling circuit, where the oil cooling circuit flows through a motor and an inverter. The method includes the following steps: determining an oil temperature at a detection point, where the detection point is a specified location in the oil cooling circuit; when the oil temperature is lower than a first target temperature, triggering one or more of the following operations: bypassing an oil-water heat exchanger, reducing a water flow rate, and increasing a power of an oil pump; or when the oil temperature is higher than a second target temperature, triggering one or more of the following operations: disabling a bypass path of an oil-water heat exchanger, increasing a water flow rate, and reducing a power of an oil pump.

It should be noted that, reducing the water flow rate may be maintaining a water flow and reducing the water flow rate, or may be stopping the water flow. The water flow rate may be adjusted by adjusting a valve in a water circuit, or may be adjusted by changing a rotation speed of a water pump or in another manner. For example, the water flow rate may be reduced by reducing the rotation speed of the water pump, or the water flow rate may be increased by increasing the rotation speed of the water pump. A specific implementation method is not limited herein.

In some possible implementations, the oil temperature at the detection point may be an oil temperature of the oil pump, an oil temperature of the motor, an oil temperature at an inverter inlet, an oil temperature at an inverter outlet, or the like.

In this implementation, the controller triggers different operations based on the oil temperatures at the detection point in the oil cooling circuit, to enable the oil temperature to be located between the first target temperature and the second target temperature, so as to control an oil temperature in a refrigeration circuit to be within a target range.

With reference to the first aspect of embodiments of this application, in some possible implementations, the determining an oil temperature at a detection point includes: directly obtaining the oil temperature at the detection point by using a sensor; or obtaining a first specified parameter, and determining the oil temperature at the detection point based on the first specified parameter, where the first specified parameter includes one or more of the following parameters: a current of the oil pump, a rotation speed of the oil pump, a current of the motor, a rotation speed of the motor, a water flow rate, and a water temperature.

With reference to the first aspect of embodiments of this application, in some possible implementations, the first target temperature and the second target temperature are determined based on a second specified parameter, and the second specified parameter includes operating scenario parameters of the electric vehicle.

With reference to the first aspect of embodiments of this application, in some possible implementations, the operating scenario parameters of the electric vehicle include a current location of the electric vehicle, and/or a current date, and/or an operation mode of the electric vehicle, where the operation mode includes a motion mode and a normal mode.

According to a second aspect, an embodiment of this application provides a controller, applied to an electric vehicle that includes an oil cooling circuit, where the oil cooling circuit flows through a motor and an inverter. The controller includes: a determining unit, configured to determine an oil temperature at a detection point, where the detection point is a specified location in the oil cooling circuit; and a processing unit, configured to: when the oil temperature is lower than a first target temperature, trigger one or more of the following operations: bypassing an oil-water heat exchanger, reducing a water flow rate, and increasing a power of an oil pump, and configured to: when the oil temperature is higher than a second target temperature, trigger one or more of the following operations: disabling a bypass path of an oil-water heat exchanger, increasing a water flow rate, and reducing a power of an oil pump.

It should be noted that, reducing the water flow rate may be maintaining a water flow and reducing the water flow rate, or may be stopping the water flow. The water flow rate may be adjusted by adjusting a valve in a water circuit, or may be adjusted by changing a rotation speed of a water pump or in another manner. For example, the water flow rate may be reduced by reducing the rotation speed of the water pump, or the water flow rate may be increased by increasing the rotation speed of the water pump. A specific implementation method is not limited herein.

With reference to the second aspect of embodiments of this application, in some possible implementations, the determining unit is specifically configured to: directly obtain the oil temperature at the detection point by using a sensor; or obtain a first specified parameter, and determine the oil temperature at the detection point based on the first specified parameter, where a first specified parameter set includes one or more of the following parameters: a current of the oil pump, a rotation speed of the oil pump, a current of the motor, a rotation speed of the motor, a water flow rate, and a water temperature.

With reference to the second aspect of embodiments of this application, in some possible implementations, the processing unit is further configured to determine the first target temperature and the second target temperature based on a second specified parameter, where the second specified parameter includes operating scenario parameters of the electric vehicle.

With reference to the second aspect of embodiments of this application, in some possible implementations, the operating scenario parameters of the electric vehicle include a current location of the electric vehicle, and/or a current date, and/or an operation mode of the electric vehicle, where the operation mode includes a motion mode and a normal mode.

According to a third aspect, an embodiment of this application provides a powertrain, including: the controller, the inverter, the motor, the water pump, the oil pump, and the oil-water heat exchanger according to any one of the first aspect or the possible implementations of the first aspect. The inverter is configured to convert a direct current into an alternating current and then transmit the alternating current to the motor. The motor is configured to convert the alternating current into mechanical energy to drive an electric vehicle to travel. The controller is configured to control a power of the oil pump and a rotation speed of the water pump. The oil-water heat exchanger is configured to transfer heat of an oil cooling circuit to a water cooling circuit.

According to a fourth aspect, an embodiment of this application provides an electric vehicle, including: the powertrain according to the third aspect and a power battery pack, where the power battery pack is configured to provide a direct current for the inverter.

According to a fifth aspect, an embodiment of this application provides a computer-readable storage medium, where the computer storage medium stores a computer program, the computer program includes program instructions, and when the program instructions are executed by a processor, the processor is enabled to implement the oil temperature control method according to any one of the first aspect or the possible implementations of the first aspect.

According to a sixth aspect, an embodiment of this application provides a computer program product, where the computer program product includes a non-transitory computer-readable storage medium that stores a computer program, and the computer program can be operated to enable a computer to implement the oil temperature control method according to any one of the first aspect or the possible implementations of the first aspect.

### BRIEF DESCRIPTION OF DRAWINGS

To describe the technical solutions in embodiments of this application more clearly, the following illustrates the accompanying drawings used in embodiments of this application.
FIG. 1 is a schematic diagram of a structure of a powertrain integrated with an oil-cooled inverter according to an embodiment of this application;
FIG. 2A is a schematic diagram of an oil temperature curve in a conventional technology;
FIG. 2B is a schematic diagram of another oil temperature curve in a conventional technology;
FIG. 2C is a schematic diagram of an oil temperature curve within a target oil temperature range;

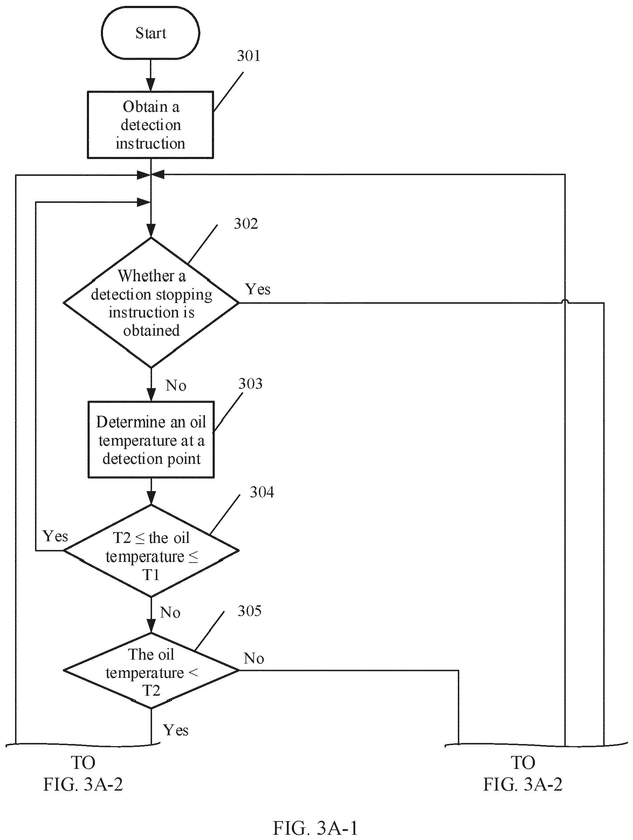

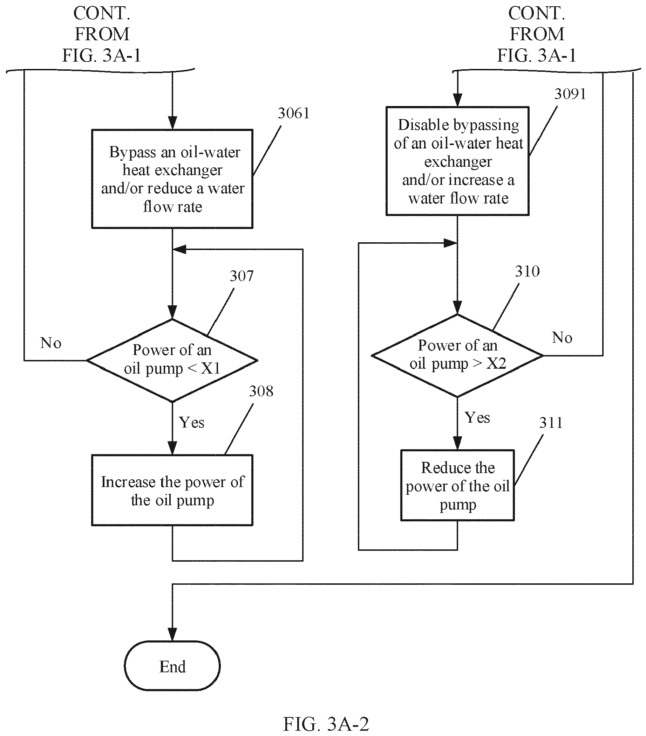

FIG. 3A-1 and FIG. 3A-2 are a schematic flowchart of an oil temperature control method according to an embodiment of this application;

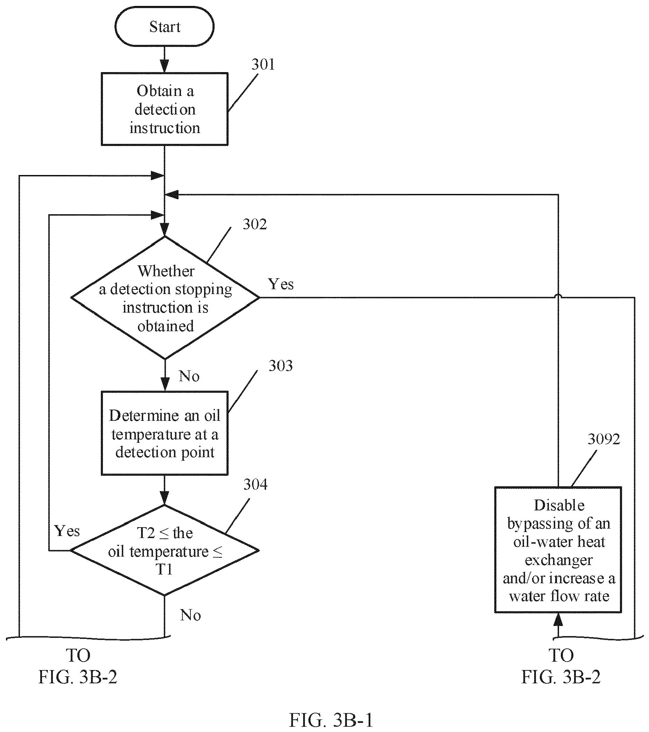

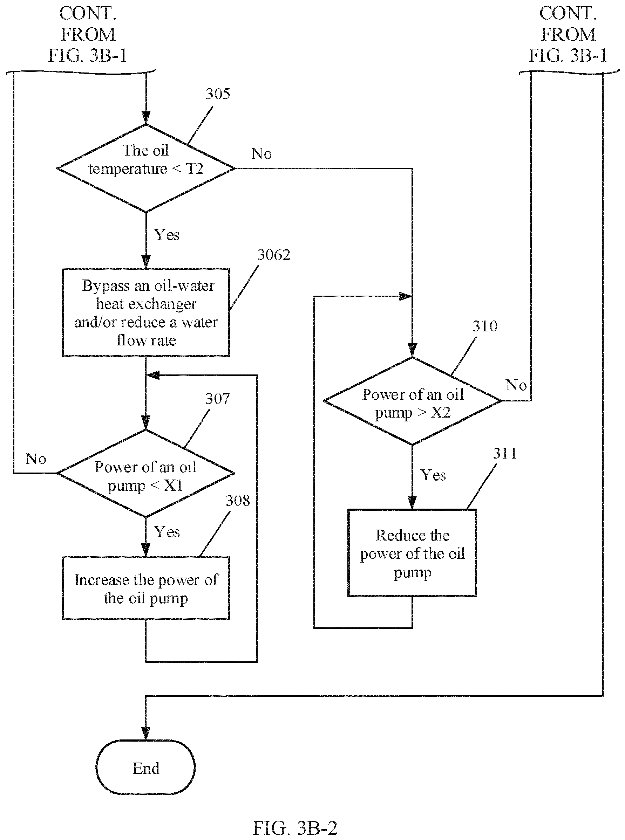

FIG. 3B-1 and FIG. 3B-2 are a schematic flowchart of an oil temperature control method according to an embodiment of this application;

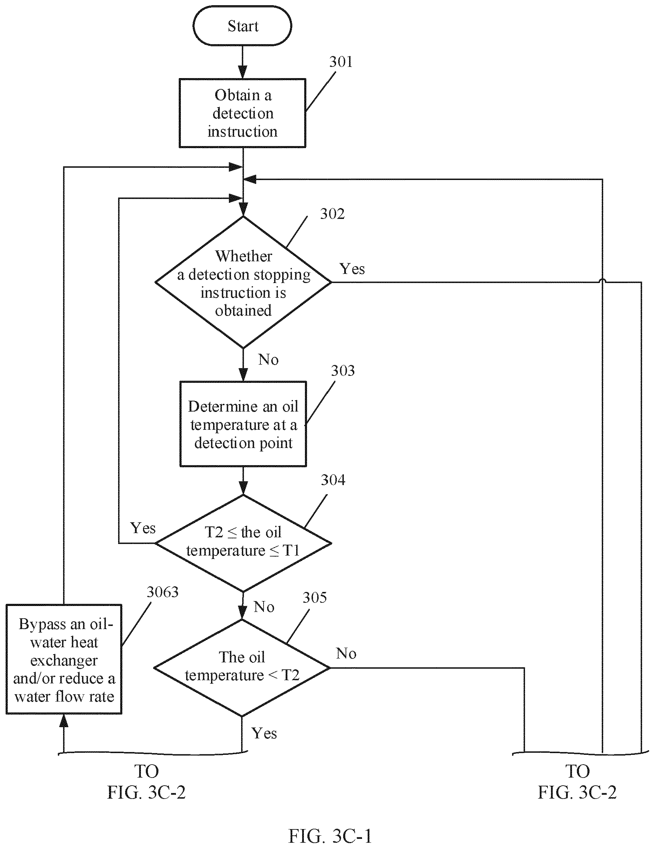

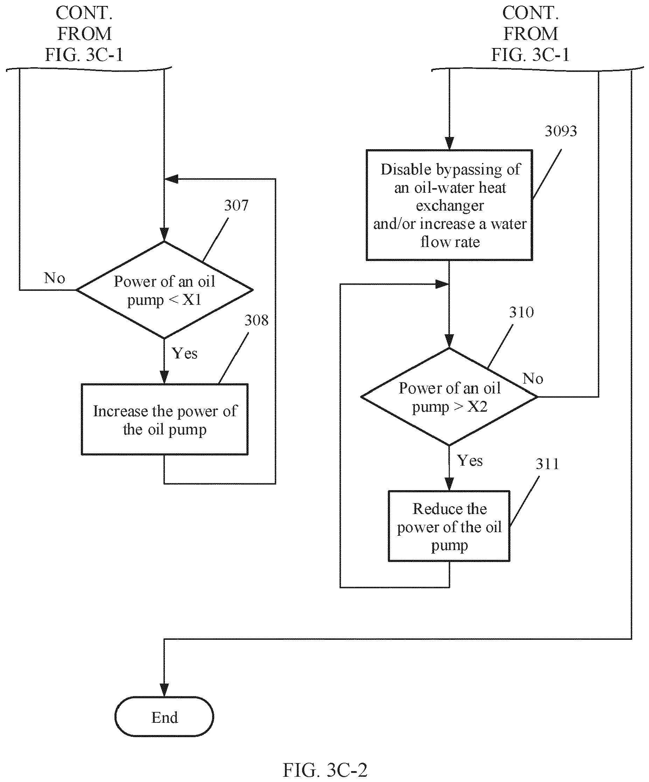

FIG. 3C-1 and FIG. 3C-2 are a schematic flowchart of an oil temperature control method according to an embodiment of this application;

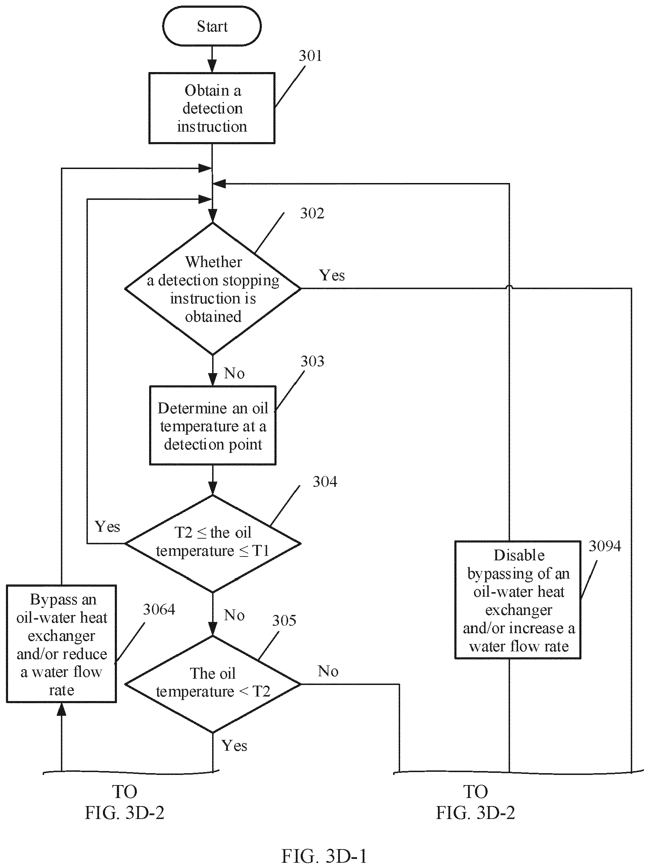

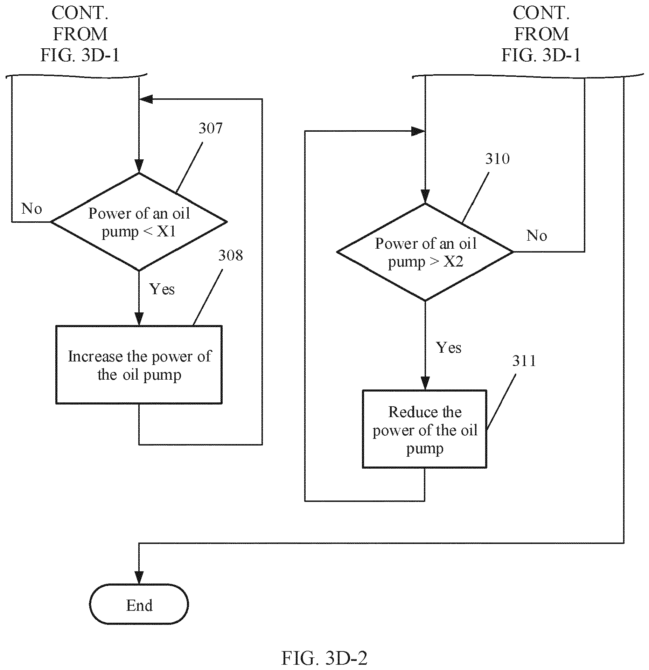

FIG. 3D-1 and FIG. 3D-2 are a schematic flowchart of an oil temperature control method according to an embodiment of this application;

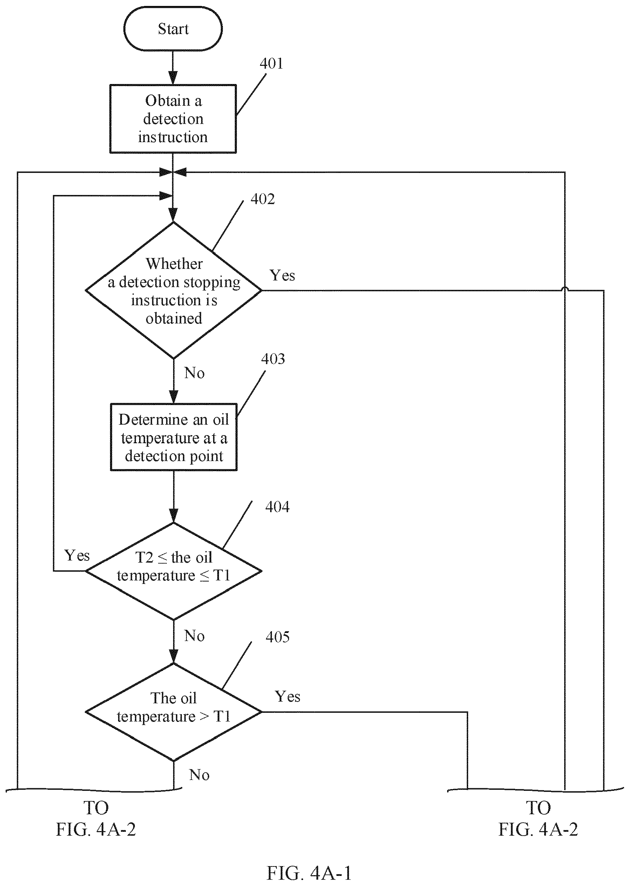

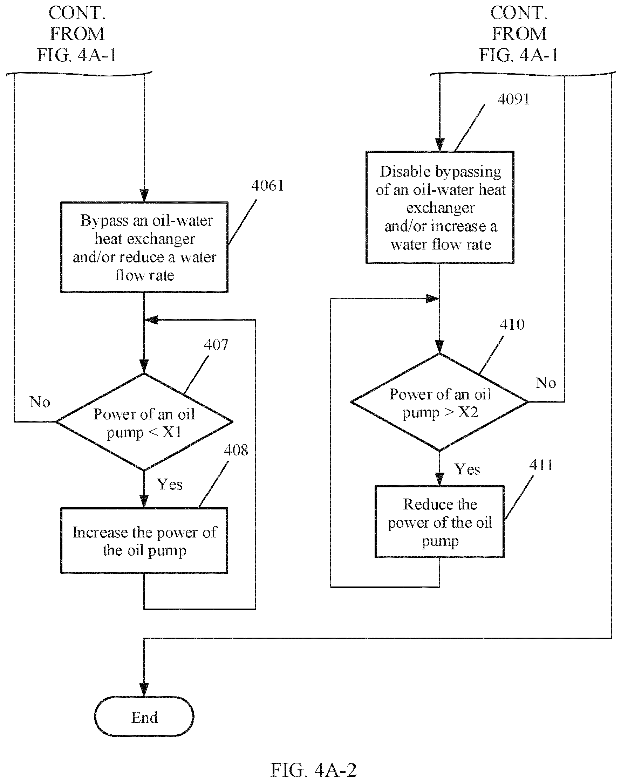

FIG. 4A-1 and FIG. 4A-2 are a schematic flowchart of an oil temperature control method according to an embodiment of this application;

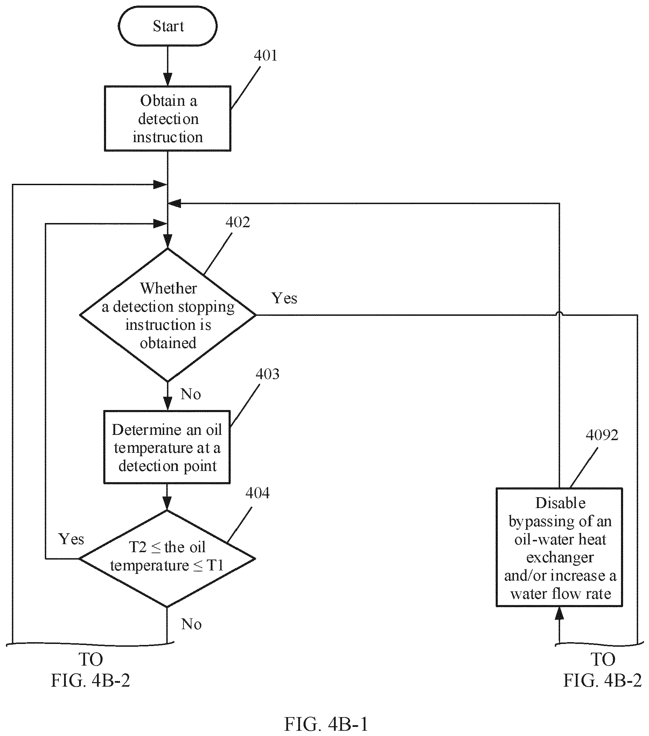

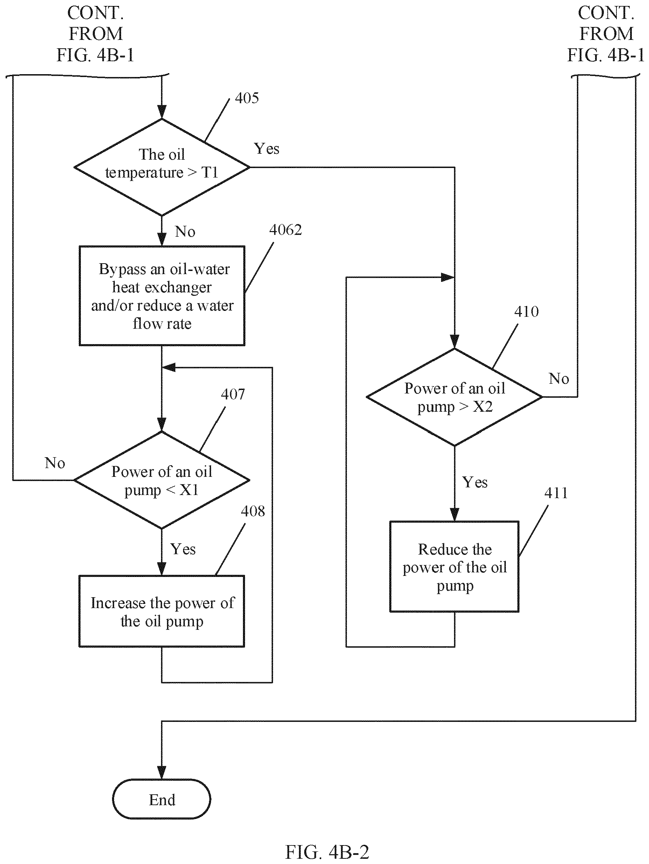

FIG. 4B-1 and FIG. 4B-2 are a schematic flowchart of an oil temperature control method according to an embodiment of this application;

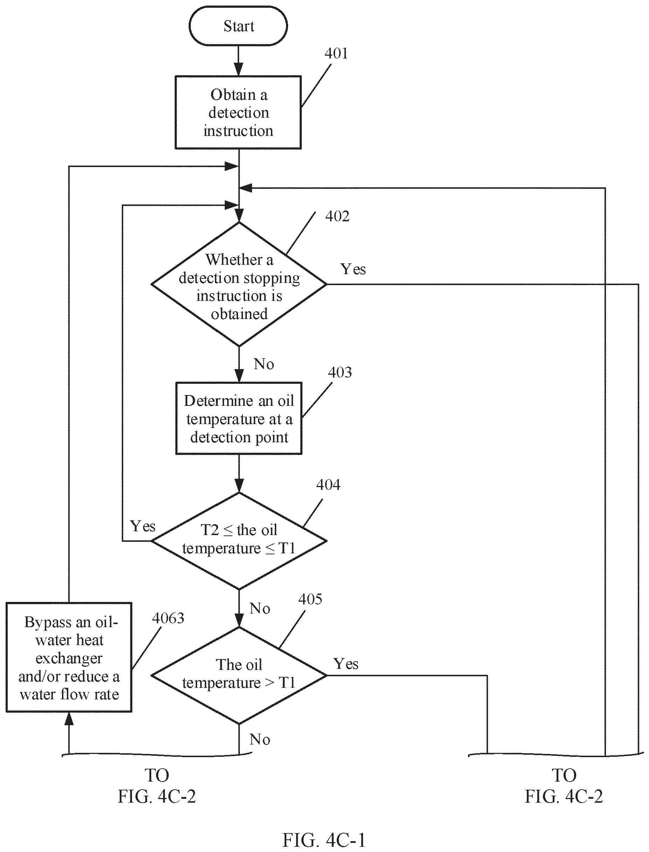

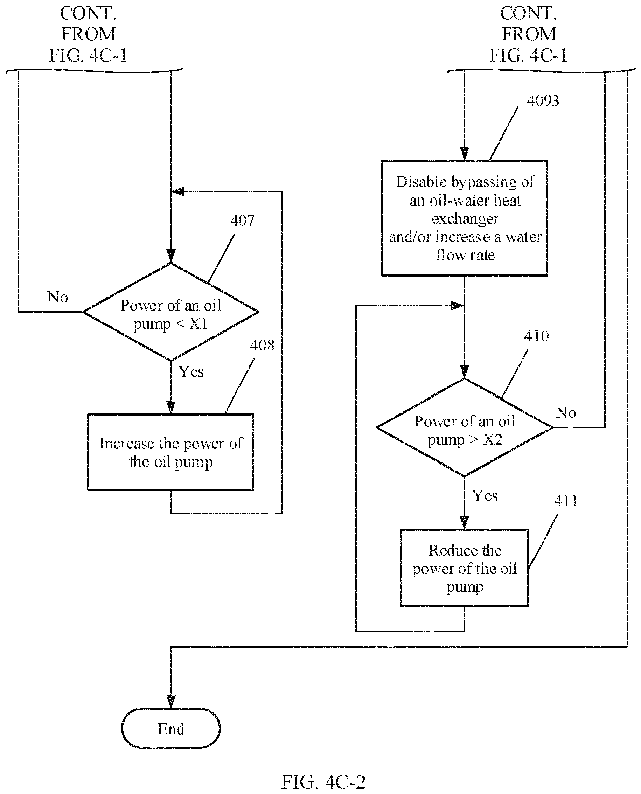

FIG. 4C-1 and FIG. 4C-2 are a schematic flowchart of an oil temperature control method according to an embodiment of this application;

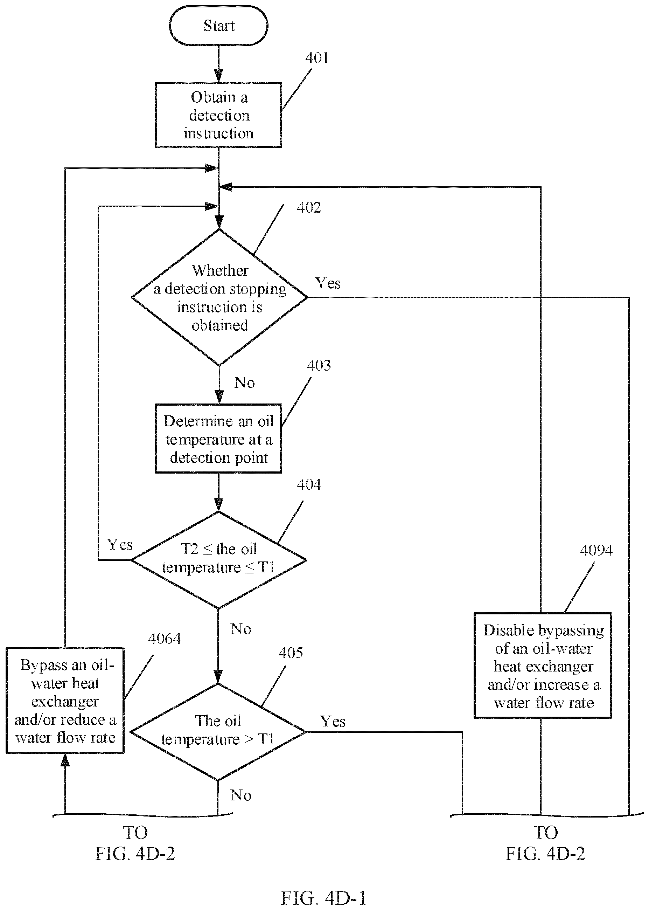

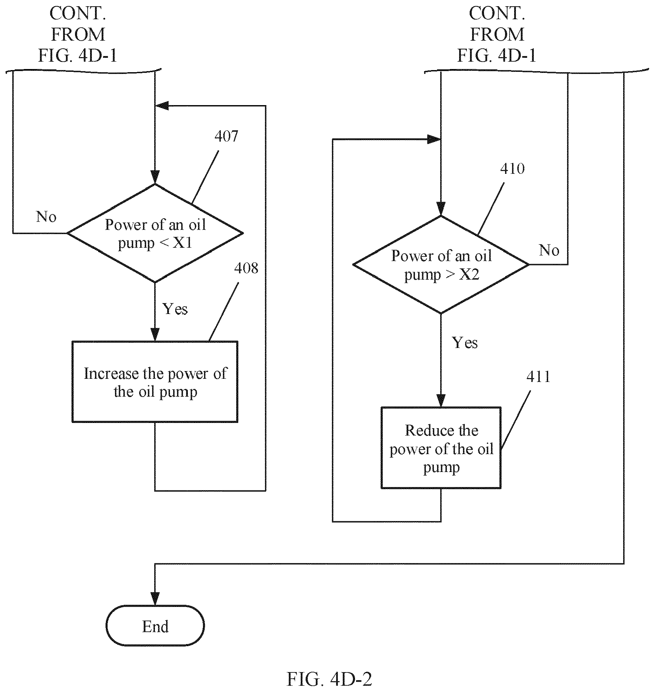

FIG. 4D-1 and FIG. 4D-2 are a schematic flowchart of an oil temperature control method according to an embodiment of this application;

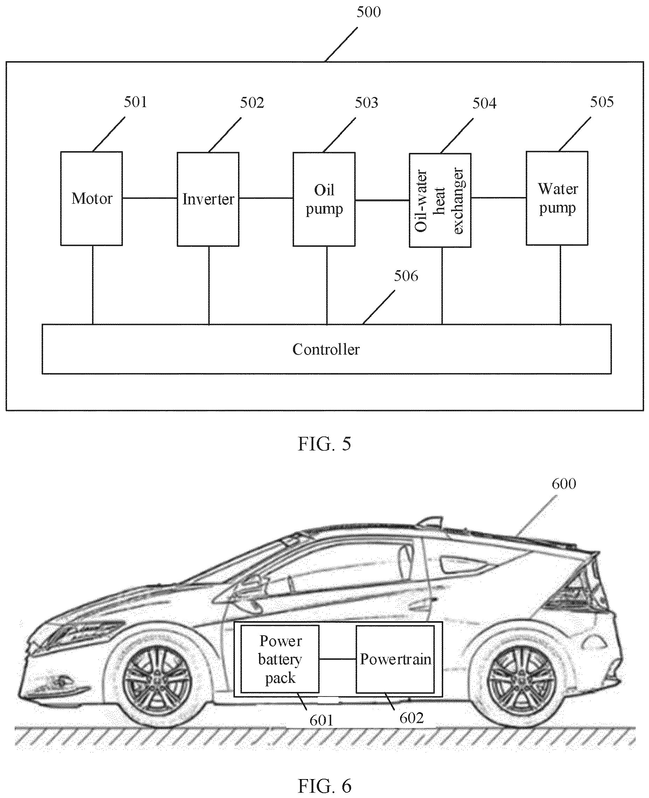

FIG. 5 is a schematic diagram of a structure of a powertrain according to an embodiment of this application; and
FIG. 6 is a schematic diagram of a structure of a network device according to an embodiment of this application.

### DESCRIPTION OF EMBODIMENTS

The following describes embodiments of this application with reference to the accompanying drawings in embodiments of this application.

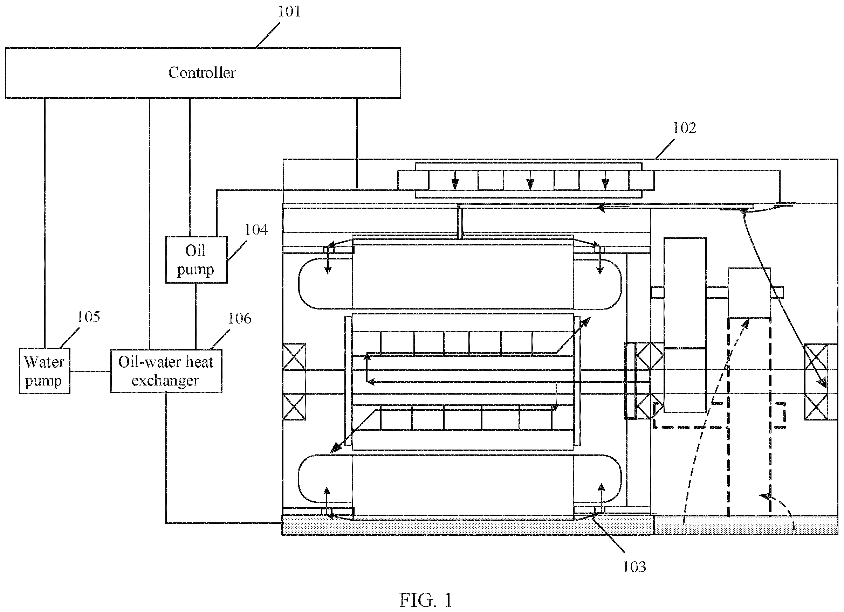

FIG. 1 is a schematic diagram of a structure of a powertrain integrated with an oil-cooled inverter according to this application.

The powertrain integrated with an oil-cooled inverter mainly includes a controller 101, an inverter 102, a motor 103, an oil pump 104, a water pump 105, an oil-water heat exchanger 106, and the like. The inverter 102 is configured to convert a direct current into an alternating current and then transmit the alternating current to the motor 103. The motor 103 is configured to convert the alternating current into mechanical energy to drive an electric vehicle to travel. The controller 101 is configured to control a power of the oil pump 104 and a rotation speed of the water pump 105 based on an oil temperature at a detection point in an oil cooling circuit. The oil-water heat exchanger 106 is configured to transfer heat of the oil cooling circuit to a water cooling circuit.

A cooling system in the powertrain includes the water cooling circuit and the oil cooling circuit. The water cooling circuit and the oil cooling circuit are not connected. The oil cooling circuit is configured to dissipate heat for the inverter 102 and the motor 103. The water cooling circuit flows through the oil-water heat exchanger 106. The oil-water heat exchanger 106 includes both a path that belongs to the water cooling circuit and a path that belongs to the oil cooling circuit, and is configured to dissipate heat for the oil cooling circuit by using the water cooling circuit. In specific implementation, the controller 101 determines the oil temperature at the detection point, where the detection point may be a specified location in the oil cooling circuit. For example, the oil temperature at the detection point may be an oil temperature of the oil pump, an oil temperature of the motor, an oil temperature at an inverter inlet, an oil temperature at an inverter outlet, or the like. The controller 101 may directly obtain the oil temperature at the detection point by using a sensor, or obtain a specified parameter, and determine the oil temperature at the detection point based on the specified parameter. The specified parameter may include one or more of the following parameters: a current of the oil pump, a rotation speed of the oil pump, a current of the motor, a rotation speed of the motor, a water flow rate, a water temperature, and the like. When the oil temperature is lower than a first target temperature, the controller 101 triggers one or more of the following operations: bypassing the oil-water heat exchanger, reducing a water flow rate, increasing the power of the oil pump, and the like. When the oil temperature is higher than a second target temperature, the controller 101 triggers one or more of the following operations: disabling a bypass path of the oil-water heat exchanger, increasing a water flow rate, and reducing the power of the oil pump. It should be noted that, the first target temperature and the second target temperature may be preset fixed values, or may be values determined based on motion scenario parameters of the electric vehicle. The motion scenario parameters of the electric vehicle may include a current location of the electric vehicle, and/or a current date, and/or an operation mode of the electric vehicle, where the operation mode of the electric vehicle may include a motion mode and a normal mode.

In this implementation, the controller triggers different operations based on the oil temperatures at the detection point in the oil cooling circuit, to enable the oil temperature to be located between the first target temperature and the second target temperature, so as to control an oil temperature in a refrigeration circuit to be within a target range.

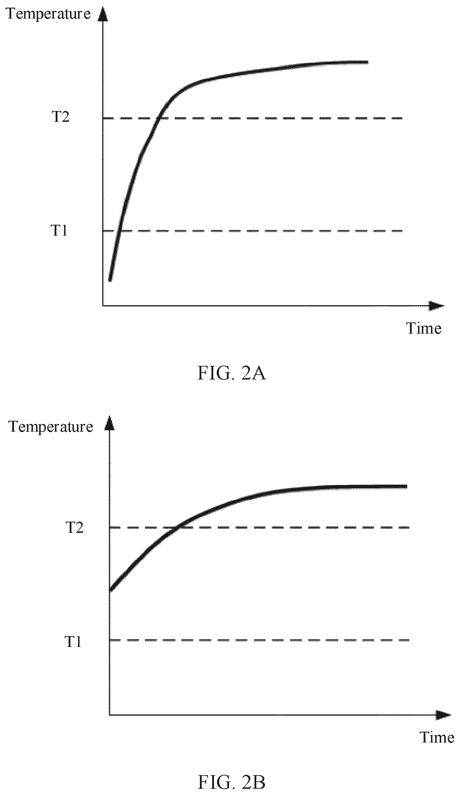

FIG. 2A is a schematic diagram of an oil temperature curve in a conventional technology. As shown in FIG. 2A, T1 is the first target temperature, and T2 is the second target temperature. The oil temperature curve shows that an initial oil temperature is lower than the first target temperature T1, and a final oil temperature is higher than the second target temperature T2.

FIG. 2B is a schematic diagram of another oil temperature curve in a conventional technology. As shown in FIG. 2B, T1 is the first target temperature, and T2 is the second target temperature. The oil temperature curve shows that an initial oil temperature is between the first target temperature T1 and the second target temperature T2, and a final oil temperature is higher than the second target temperature T2.

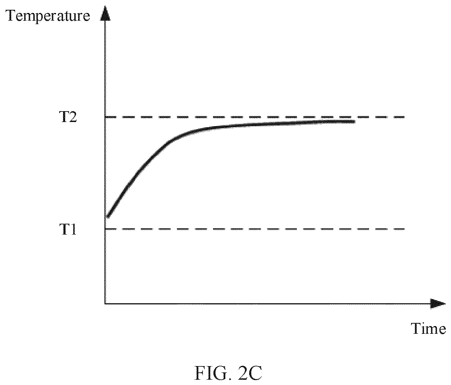

FIG. 2C is a schematic diagram of an oil temperature curve in a target temperature range. As shown in FIG. 2C, T1 is the first target temperature, and T2 is the second target temperature. The oil temperature curve shows that an oil temperature is between the first target temperature T1 and the second target temperature T2. A target temperature curve controlled by using the controller is also that an oil temperature curve is between the first target temperature T1 and the second target temperature T2. This helps improve a heat dissipation effect of the powertrain integrated with an oil-cooled inverter.

To make a person skilled in the art understand the technical solutions in this application better, the following describes the technical solutions in embodiments of this application with reference to the accompanying drawings in embodiments of this application.

The terms such as "first" and "second" in this application are merely intended for a purpose of description, and shall not be understood as an indication or implication of relative importance or implicit indication of a quantity of indicated technical features.

In addition, in this application, orientation terms such as "up" and "down" may include but are not limited to orientations schematically placed relative to components in the accompanying drawings. It should be understood that these directional terms may be relative concepts, and are used for relative description and clarification, and may be correspondingly changed based on changes in placement orientations of the components in the accompanying drawings. In this application, unless otherwise expressly specified and limited, the term "connection" should be understood in a broad sense. For example, "connection" may be a fixed connection, a detachable connection, or an integrated connection, or may be a direct connection or an indirect connection through an intermediate medium. In this application, when an oil cooling circuit is described, for ease of description, a "circuit" or a "path" may be used instead of a "pipeline" in a physical structure or a container that can carry a cooling medium.

### Embodiment 1

This embodiment of this application provides an oil temperature control method, which is described in detail below with reference to FIG. 3A-1 and FIG. 3A-2. FIG. 3A-1 and FIG. 3A-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

301: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

302: Determine whether a detection stopping instruction is obtained.

If yes, a control procedure ends. If no, step 303 is performed.

303: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

304: Determine whether the oil temperature meets the following condition: T2 ≤ the oil temperature ≤ T1.

If yes, step 302 is performed. If no, step 305 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

305: Determine whether the oil temperature is less than T2.

If yes, step 3061 is performed. If no, step 3091 is performed.

3061: Bypass an oil-water heat exchanger and/or reduce a water flow rate.

It should be noted that, these control manners may be used separately or in combination as required.

It should be noted that, reducing the water flow rate may be maintaining a water flow and reducing the water flow rate, or may be stopping the water flow. The water flow rate may be adjusted by adjusting a valve in a water circuit, or may be adjusted by changing a rotation speed of a water pump or in another manner. For example, the water flow rate may be reduced by reducing the rotation speed of the water pump, or the water flow rate may be increased by increasing the rotation speed of the water pump. A specific implementation method is not limited herein.

307: Determine whether a power of the oil pump is less than X1.

If yes, step 308 is performed. If no, step 302 is performed.

308: Increase the power of the oil pump.

It should be noted that, in some possible implementations, the power of the oil pump may be increased by a predetermined value each time. The predetermined value may be a fixed value, or may be a value changed based on a specified condition. Step 307 may be performed again every predetermined time to determine whether an adjusted power of the oil pump is less than X1.

3091: Disable a bypass path of an oil-water heat exchanger and/or increase a water flow rate.

310: Determine whether the power of the oil pump is greater than X2.

If yes, step 311 is performed. If no, step 3091 is performed.

311: Reduce the power of the oil pump.

It should be noted that, in some possible implementations, the power of the oil pump may be reduced by a predetermined value each time. Step 310 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

### Embodiment 2

This embodiment of this application provides an oil temperature control method, which is described in detail below with reference to FIG. 3B-1 and FIG. 3B-2. FIG. 3B-1 and FIG. 3B-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

301: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

302: Determine whether a detection stopping instruction is obtained.

If yes, a control procedure ends. If no, step 303 is performed.

303: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

304: Determine whether the oil temperature meets the following condition: T2 ≤ the oil temperature ≤ T1.

If yes, step 302 is performed. If no, step 305 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

305: Determine whether the oil temperature is less than T2.

If yes, step 3062 is performed. If no, step 310 is performed.

3062: Bypass an oil-water heat exchanger and/or reduce a water flow rate.

It should be noted that, these control manners may be used separately or in combination as required.

307: Determine whether a power of the oil pump is less than X1.

If yes, step 308 is performed. If no, step 302 is performed.

308: Increase the power of the oil pump.

It should be noted that, in some possible implementations, the power of the oil pump may be increased by a predetermined value each time. The predetermined value may be a fixed value, or may be a value changed based on a specified condition. Step 307 may be performed again every predetermined time to determine whether an adjusted power of the oil pump is less than X1.

310: Determine whether the power of the oil pump is greater than X2.

If yes, step 311 is performed. If no, step 3092 is performed.

3092: Disable a bypass path of an oil-water heat exchanger and/or increase a water flow rate.

311: Reduce the power of the oil pump.

It should be noted that, in some possible implementations, the power of the oil pump may be reduced by a predetermined value each time. Step 310 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

### Embodiment 3

This embodiment of this application provides an oil temperature control method, which is described in detail below with reference to FIG. 3C-1 and FIG. 3C-2. FIG. 3C-1 and FIG. 3C-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

301: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

302: Determine whether a detection stopping instruction is obtained.

If yes, a control procedure ends. If no, step 303 is performed.

303: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

304: Determine whether the oil temperature meets the following condition: T2 ≤ the oil temperature ≤ T1.

If yes, step 302 is performed. If no, step 305 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

305: Determine whether the oil temperature is less than T2.

If yes, step 307 is performed. If no, step 3093 is performed.

307: Determine whether a power of the oil pump is less than X1.

If yes, step 308 is performed. If no, step 3063 is performed.

3063: Bypass an oil-water heat exchanger and/or reduce a water flow rate.

It should be noted that, these control manners may be used separately or in combination as required.

308: Increase the power of the oil pump.

It should be noted that, in some possible implementations, the power of the oil pump may be increased by a predetermined value each time. The predetermined value may be a fixed value, or may be a value changed based on a specified condition. Step 307 may be performed again every predetermined time to determine whether an adjusted power of the oil pump is less than X1.

3093: Disable a bypass path of an oil-water heat exchanger and/or increase a water flow rate.

310: Determine whether the power of the oil pump is greater than X2.

If yes, step 311 is performed. If no, step 302 is performed.

311: Reduce the power of the oil pump.

It should be noted that, in some possible implementations, the power of the oil pump may be reduced by a predetermined value each time. Step 310 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

### Embodiment 4

This embodiment of this application provides an oil temperature control method, which is described in detail below with reference to FIG. 3D-1 and FIG. 3D-2. FIG. 3D-1 and FIG. 3D-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

301: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

302: Determine whether a detection stopping instruction is obtained.

If yes, a control procedure ends. If no, step 303 is performed.

303: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

304: Determine whether the oil temperature meets the following condition: T2 ≤ the oil temperature ≤ T1.

If yes, step 302 is performed. If no, step 305 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

305: Determine whether the oil temperature is less than T2.

If yes, step 307 is performed. If no, step 310 is performed.

307: Determine whether a power of the oil pump is less than X1.

If yes, step 308 is performed. If no, step 3064 is performed.

3064: Bypass an oil-water heat exchanger and/or reduce a water flow rate.

It should be noted that, these control manners may be used separately or in combination as required.

308: Increase the power of the oil pump.

It should be noted that, in some possible implementations, the power of the oil pump may be increased by a predetermined value each time. The predetermined value may be a fixed value, or may be a value changed based on a specified condition. Step 307 may be performed again every predetermined time to determine whether an adjusted power of the oil pump is less than X1.

310: Determine whether the power of the oil pump is greater than X2.

If yes, step 311 is performed. If no, step 3094 is performed.

3094: Disable a bypass path of an oil-water heat exchanger and/or increase a water flow rate.

311: Reduce the power of the oil pump.

It should be noted that, in some possible implementations, the power of the oil pump may be reduced by a predetermined value each time. Step 310 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

### Embodiment 5

This embodiment of this application provides an oil temperature control method, which is described in detail below with reference to FIG. 4A-1 and FIG. 4A-2. FIG. 4A-1 and FIG. 4A-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

401: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

402: Determine whether a detection stopping instruction is obtained.

If yes, a control procedure ends. If no, step 403 is performed.

403: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

404: Determine whether the oil temperature meets the following condition: T2 ≤ the oil temperature ≤ T1.

If yes, step 402 is performed. If no, step 405 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

405: Determine whether the oil temperature is greater than T1.

If yes, step 4091 is performed. If no, step 4061 is performed.

4061: Bypass an oil-water heat exchanger and/or reduce a water flow rate.

It should be noted that, these control manners may be used separately or in combination as required.

407: Determine whether a power of the oil pump is less than X1.

If yes, step 408 is performed. If no, step 402 is performed.

408: Increase the power of the oil pump.

It should be noted that, in some possible implementations, the power of the oil pump may be increased by a predetermined value each time. The predetermined value may be a fixed value, or may be a value changed based on a specified condition. Step 407 may be performed again every predetermined time to determine whether an adjusted power of the oil pump is less than X1.

4091: Disable a bypass path of an oil-water heat exchanger and/or increase a water flow rate.

410: Determine whether the power of the oil pump is greater than X2.

If yes, step 411 is performed. If no, step 402 is performed.

411: Reduce the power of the oil pump.

It should be noted that, in some possible implementations, the power of the oil pump may be reduced by a predetermined value each time. Step 410 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

### Embodiment 6

This embodiment of this application provides an oil temperature control method, which is described in detail below with reference to FIG. 4B-1 and FIG. 4B-2. FIG. 4B-1 and FIG. 4B-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

401: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

402: Determine whether a detection stopping instruction is obtained.

If yes, a control procedure ends. If no, step 403 is performed.

403: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

404: Determine whether the oil temperature meets the following condition: T2 ≤ the oil temperature ≤ T1.

If yes, step 402 is performed. If no, step 405 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

405: Determine whether the oil temperature is greater than T1.

If yes, step 410 is performed. If no, step 4062 is performed.

4062: Bypass an oil-water heat exchanger and/or reduce a water flow rate.

It should be noted that, these control manners may be used separately or in combination as required.

407: Determine whether a power of the oil pump is less than X1.

If yes, step 408 is performed. If no, step 402 is performed.

408: Increase the power of the oil pump.

It should be noted that, in some possible implementations, the power of the oil pump may be increased by a predetermined value each time. The predetermined value may be a fixed value, or may be a value changed based on a specified condition. Step 407 may be performed again every predetermined time to determine whether an adjusted power of the oil pump is less than X1.

410: Determine whether the power of the oil pump is greater than X2.

If yes, step 411 is performed. If no, step 4092 is performed.

4092: Disable a bypass path of an oil-water heat exchanger and/or increase a water flow rate.

411: Reduce the power of the oil pump.

It should be noted that, in some possible implementations, the power of the oil pump may be reduced by a predetermined value each time. Step 410 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

### Embodiment 7

This embodiment of this application provides an oil temperature control method, which is described in detail below with reference to FIG. 4C-1 and FIG. 4C-2. FIG. 4C-1 and FIG. 4C-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

401: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

402: Determine whether a detection stopping instruction is obtained.

If yes, a control procedure ends. If no, step 403 is performed.

403: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

404: Determine whether the oil temperature meets the following condition: T2 ≤ the oil temperature ≤ T1.

If yes, step 402 is performed. If no, step 405 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

405: Determine whether the oil temperature is greater than T1.

If yes, step 4093 is performed. If no, step 407 is performed.

407: Determine whether a power of the oil pump is less than X1.

If yes, step 408 is performed. If no, step 4063 is performed.

4063: Bypass an oil-water heat exchanger and/or reduce a water flow rate.

It should be noted that, these control manners may be used separately or in combination as required.

408: Increase the power of the oil pump.

It should be noted that, in some possible implementations, the power of the oil pump may be increased by a predetermined value each time. The predetermined value may be a fixed value, or may be a value changed based on a specified condition. Step 407 may be performed again every predetermined time to determine whether an adjusted power of the oil pump is less than X1.

4093: Disable a bypass path of an oil-water heat exchanger and/or increase a water flow rate.

410: Determine whether the power of the oil pump is greater than X2.

If yes, step 411 is performed. If no, step 402 is performed.

411: Reduce the power of the oil pump.

It should be noted that, in some possible implementations, the power of the oil pump may be reduced by a predetermined value each time. Step 410 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

### Embodiment 8

This embodiment of this application provides an oil temperature control method, which is described in detail below with reference to FIG. 4D-1 and FIG. 4D-2. FIG. 4D-1 and FIG. 4D-2 are a schematic flowchart of an oil temperature control method according to an embodiment of this application. The method is applied to a controller of an electric vehicle that includes an oil cooling circuit. The oil cooling circuit flows through a motor and an inverter. The oil temperature control method includes the following steps.

401: Obtain a detection instruction.

For example, if the detection instruction may be triggered by default after the electric vehicle is started, the controller obtains the detection instruction after the electric vehicle is started. It may be understood that, the detection instruction may be alternatively triggered by another operation or event, which is not limited herein.

402: Determine whether a detection stopping instruction is obtained.

If yes, a control procedure ends. If no, step 403 is performed.

403: Determine an oil temperature at a detection point.

In some possible implementations, the oil temperature at the detection point may be obtained by using a temperature sensor. In some other embodiments, a first specified parameter may be obtained, and the oil temperature at the detection point is determined based on the first specified parameter. The first specified parameter may include one or more of the following parameters: a current of an oil pump, a rotation speed of the oil pump, a current of the motor, a rotation speed of the motor, a water flow rate, a water temperature, and the like. The oil temperature at the detection point may be an oil temperature of the oil pump, an oil temperature of the motor, an oil temperature at an inverter inlet, an oil temperature at an inverter outlet, or the like.

404: Determine whether the oil temperature meets the following condition: T2 ≤ the oil temperature ≤ T1.

If yes, step 402 is performed. If no, step 405 is performed. T1 is a first target temperature, and T2 is a second target temperature. The first target temperature T1 and the second target temperature T2 may be preset fixed values, or may be values determined based on motion scenario parameters of the electric vehicle. The motion scenario parameters of the electric vehicle may include a current location of the electric vehicle, and/or a current date, and/or an operation mode of the electric vehicle, and/or the like, where the operation mode of the electric vehicle may include a motion mode, a normal mode, and the like.

405: Determine whether the oil temperature is greater than T1.

If yes, step 410 is performed. If no, step 407 is performed.

407: Determine whether a power of the oil pump is less than X1.

If yes, step 408 is performed. If no, step 4064 is performed.

4064: Bypass an oil-water heat exchanger and/or reduce a water flow rate.

It should be noted that, these control manners may be used separately or in combination as required.

408: Increase the power of the oil pump.

It should be noted that, in some possible implementations, the power of the oil pump may be increased by a predetermined value each time. The predetermined value may be a fixed value, or may be a value changed based on a specified condition. Step 407 may be performed again every predetermined time to determine whether an adjusted power of the oil pump is less than X1.

410: Determine whether the power of the oil pump is greater than X2.

If yes, step 411 is performed. If no, step 4094 is performed.

4094: Disable a bypass path of an oil-water heat exchanger and/or increase a water flow rate.

411: Reduce the power of the oil pump.

It should be noted that, in some possible implementations, the power of the oil pump may be reduced by a predetermined value each time. Step 410 may be performed again every predetermined time to determine whether an adjusted power of the oil pump is greater than X2.

In this implementation, the controller triggers different operations based on the oil temperatures at the detection point in the oil cooling circuit, to enable the oil temperature in the oil cooling circuit to be located between the first target temperature and the second target temperature.

An embodiment of this application further provides a controller, applied to an electric vehicle that includes an oil cooling circuit, where the oil cooling circuit flows through a motor and an inverter. The controller includes: a determining unit, configured to determine an oil temperature at a detection point, where the detection point is a specified location in the oil cooling circuit; and a processing unit, configured to: when the oil temperature is lower than a first target temperature, trigger one or more of the following operations: bypassing an oil-water heat exchanger, reducing a water flow rate, and increasing a power of an oil pump, and configured to: when the oil temperature is higher than a second target temperature, trigger one or more of the following operations: disabling a bypass path of an oil-water heat exchanger, increasing a water flow rate, and reducing a power of an oil pump. The determining unit may directly obtain the oil temperature at the detection point by using a sensor, or obtain a first specified parameter, and determine the oil temperature at the detection point based on the first specified parameter. A first specified parameter set includes one or more of the following parameters: a current of the oil pump, a rotation speed of the oil pump, a current of the motor, a rotation speed of the motor, a water flow rate, and a water temperature. The processing unit may be further configured to determine the first target temperature and the second target temperature based on a second specified parameter, where the second specified parameter includes operating scenario parameters of the electric vehicle. The operating scenario parameters of the electric vehicle include a current location of the electric vehicle, and/or a current date, and/or an operation mode of the electric vehicle, where the operation mode may include a motion mode and a normal mode.

Referring to FIG. 5, an embodiment of this application provides a powertrain 500, including a motor 501, an inverter 502, an oil pump 503, an oil-water heat exchanger 504, a water pump 505, and a controller 506. The inverter 502 is configured to convert a direct current into an alternating current and then transmit the alternating current to the motor 501. The motor 501 is configured to convert the alternating current into mechanical energy to drive an electric vehicle to travel. The controller 506 is configured to control a power of the oil pump 503 and a rotation speed of the water pump 505. The oil-water heat exchanger 504 is configured to transfer heat of an oil cooling circuit to a water cooling circuit. The controller 506 is specifically configured to perform the oil temperature control method according to any one of the embodiments in FIG. 3A-1 and FIG. 3A-2 to FIG. 4D-1 and FIG. 4D-2. For specific details, refer to the foregoing description. Details are not described herein again.

Referring to FIG. 6, an embodiment of this application further provides an electric vehicle 600, including a power battery pack 601 and a powertrain 602. The power battery pack 601 is configured to supply power to the powertrain 602. The powertrain 602 is shown in FIG. 5. Reference is made to the foregoing description, and details are not described herein again.

This application further provides a computer-readable storage medium, which stores a computer program. For an implementation and beneficial effects of resolving a problem by using the program, refer to implementations and beneficial effects of the oil temperature control method in FIG. 3A-1 and FIG. 3A-2 to FIG. 4D-1 and FIG. 4D-2. No repeated description is provided.

An embodiment of this application further provides a computer program product, where the computer program product includes a non-volatile computer-readable storage medium that stores a computer program. When the computer program is executed, a computer is enabled to perform the steps of the oil temperature control method in the embodiments corresponding to FIG. 3A-1 and FIG. 3A-2 to FIG. 4D-1 and FIG. 4D-2. For an implementation and beneficial effects of resolving a problem by using the computer program product, refer to implementations and beneficial effects of the oil temperature control method in FIG. 3A-1 and FIG. 3A-2 to FIG. 4D-1 and FIG. 4D-2. No repeated description is provided.

A person of ordinary skill in the art may understand that all or some of the processes of the methods in embodiments may be implemented by a computer program instructing relevant hardware. The program may be stored in a computer-readable storage medium. When the program runs, the processes of the methods in embodiments are performed.

It should be understood that, in this application, "at least one (item)" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between associated objects. "At least one of the following items (pieces)" or a similar expression thereof refers to any combination of these items, including any combination of singular items (pieces) or plural items (pieces). For example, at least one item (piece) of a, b, or c may indicate a, b, c, a and b, a and c, b and c, or a, b, and c, where a, b, and c may be singular or plural.

The apparatus embodiments described above are merely examples, and the units and modules described as separate parts may or may not be physically separate. Some or all of the units and modules may be selected based on an actual requirement to achieve the objectives of the solutions of the embodiments. A person of ordinary skill in the art may understand and implement embodiments without creative efforts.

The foregoing descriptions are merely specific implementations of this application. It should be noted that a person of ordinary skill in the art may make several improvements or polishing without departing from the principle of this application and the improvements or polishing shall fall within the protection scope of this application.

## Claims

1. An oil temperature control method, applied to a controller of an electric vehicle that comprises an oil cooling circuit, wherein the oil cooling circuit flows through a motor and an inverter, and the method comprises the following steps:
determining an oil temperature at a detection point, wherein the detection point is a specified location in the oil cooling circuit;
when the oil temperature is lower than a first target temperature, triggering one or more of the following operations: bypassing an oil-water heat exchanger, reducing a water flow rate, and increasing a power of an oil pump; or
when the oil temperature is higher than a second target temperature, triggering one or more of the following operations: disabling a bypass path of an oil-water heat exchanger, increasing a water flow rate, and reducing a power of an oil pump.

2. The method according to claim 1, wherein the determining an oil temperature at a detection point comprises:
directly obtaining the oil temperature at the detection point by using a sensor; or
obtaining a first specified parameter, and determining the oil temperature at the detection point based on the first specified parameter, wherein the first specified parameter comprises one or more of the following parameters: a current of the oil pump, a rotation speed of the oil pump, a current of the motor, a rotation speed of the motor, a water flow rate, and a water temperature.

3. The method according to claim 1 or 2, wherein the first target temperature and the second target temperature are determined based on a second specified parameter, and the second specified parameter comprises operating scenario parameters of the electric vehicle.

4. The method according to claim 3, wherein the operating scenario parameters of the electric vehicle comprise a current location of the electric vehicle, and/or a current date, and/or an operation mode of the electric vehicle, wherein the operation mode comprises a motion mode and a normal mode.

5. A controller, applied to an electric vehicle that comprises an oil cooling circuit, wherein the oil cooling circuit flows through a motor and an inverter, and the controller comprises:
a determining unit, configured to determine an oil temperature at a detection point, wherein the detection point is a specified location in the oil cooling circuit; and
a processing unit, configured to: when the oil temperature is lower than a first target temperature, trigger one or more of the following operations: bypassing an oil-water heat exchanger, reducing a water flow rate, and increasing a power of an oil pump, and configured to: when the oil temperature is higher than a second target temperature, trigger one or more of the following operations: disabling a bypass path of an oil-water heat exchanger, increasing a water flow rate, and reducing a power of an oil pump.

6. The controller according to claim 5, wherein
the determining unit is specifically configured to: directly obtain the oil temperature at the detection point by using a sensor; or obtain a first specified parameter, and determine the oil temperature at the detection point based on the first specified parameter, wherein a first specified parameter set comprises one or more of the following parameters: a current of the oil pump, a rotation speed of the oil pump, a current of the motor, a rotation speed of the motor, a water flow rate, and a water temperature.

7. The controller according to claim 5 or 6, wherein
the processing unit is further configured to determine the first target temperature and the second target temperature based on a second specified parameter, wherein the second specified parameter comprises operating scenario parameters of the electric vehicle.

8. The controller according to claim 7, wherein the operating scenario parameters of the electric vehicle comprise a current location of the electric vehicle, and/or a current date, and/or an operation mode of the electric vehicle, wherein the operation mode comprises a motion mode and a normal mode.

9. A powertrain, comprising: the controller, the inverter, the motor, the water pump, the oil pump, and the oil-water heat exchanger according to any one of claims 5 to 8, wherein
the inverter is configured to convert a direct current into an alternating current and then transmit the alternating current to the motor;
the motor is configured to convert the alternating current into mechanical energy to drive an electric vehicle to travel;
the controller is configured to control a power of the oil pump and a rotation speed of the water pump; and
the oil-water heat exchanger is configured to transfer heat of an oil cooling circuit to a water cooling circuit.

10. An electric vehicle, comprising: the powertrain according to claim 9 and a power battery pack, wherein the power battery pack is configured to provide a direct current for the inverter.
